# EUROPEAN PATENT SPECIFICATION

(11) **EP 4 539 623 B1**
(45) Date of publication and mention of the grant of the patent: **30.09.2026**
(21) Application number: 23846804.5
(22) Date of filing: 13.06.2023
(51) Int. Cl.: G06F 1/20, G06F 1/16, H04M 1/02

(54) **ELECTRONIC DEVICE COMPRISING STRUCTURE FOR DISSIPATING HEAT**
ELEKTRONISCHE VORRICHTUNG MIT STRUKTUR ZUR WÄRMEABLEITUNG
DISPOSITIF ÉLECTRONIQUE COMPRENANT UNE STRUCTURE DE DISSIPATION DE CHALEUR

(30) Priority: 25.07.2022 KR 20220091935; 01.09.2022 KR 20220111033
(43) Date of publication of application: 16.04.2025
(73) Proprietor: Samsung Electronics Co., Ltd., Suwon-si, Gyeonggi-do 16677 (KR)
(72) Inventor: KIM, Seungkyu, Suwon-si Gyeonggi-do 16677 (KR); KIM, Minsoo, Suwon-si Gyeonggi-do 16677 (KR); SEONG, Youngseob, Suwon-si Gyeonggi-do 16677 (KR); AN, Jinwan, Suwon-si Gyeonggi-do 16677 (KR)
(74) Representative: Nederlandsch Octrooibureau
(86) International application number: PCT/KR2023/008080
(87) International publication number: WO 2024/025144

(56) References cited:
- EP-A1- 4 394 546
- CN-A- 113 178 135
- KR-A- 20220 061 807
- KR-A- 20220 077 363
- KR-A- 20220 085 793
- US-A1- 2015 220 122
- US-A1- 2020 264 660
- US-A1- 2021 278 886
- US-A1- 2022 151 106

## Description

### [Technical Field]

The present disclosure relates to an electronic device comprising a structure for dissipating heat.

### [Background Art]

In order for a user to easily carry an electronic device, the electronic device may be miniaturized. Despite miniaturization of the electronic device, there is an increasing need for the electronic device in which a size of a display for displaying contents may be changed so that the user may be provided with various contents through the electronic device. For example, the electronic device may include a flexible display in which the size of the display exposed to an outside of the electronic device may be changed.
US 2022/0151106 A1 describes an electronic device including heat dissipation member. An electronic device is provided, which may include a first housing; a second housing configured to accommodate at least a portion of the first housing and guide a sliding movement of the first housing; a display including a first display area disposed on the first housing and a second display area extending from the first display area; a PCB configured to accommodate at least one electronic component; a support member configured to support the PCB; a side wall member connected to the support member and facing at least a portion of the first housing; a heat dissipation sheet configured to receive heat from the at least one electronic component, the heat dissipation sheet being disposed on the support member and the side wall member; and a heat dissipation member disposed on the side wall member and facing the heat dissipation sheet.
EP 4 394 546 A1, cited as prior art under Art. 54(3) EPC, describes an electronic device capable of sliding. An electronic device according to various embodiments comprises: a fixer housing; a mover housing which is coupled to be slidable with respect to the fixer housing; a moving motor which is fixed to one of the fixer housing and the mover housing; a gear member which is fixed to the other between the fixer housing and the mover housing and is engaged with the moving motor; an inner space which has a motor accommodation portion accommodating the moving motor, and is formed by the fixer housing and the mover housing; a printed circuit board comprising a processor and arranged in the inner space; a vent hole formed in at least one of the fixer housing and the mover housing to be connected to the motor accommodation portion; and an outer hole connecting the vent hole and the outside of the electronic device.

### [Disclosure]

### [Technical Solution]

According to an embodiment, an electronic device may include a first housing. According to an embodiment, the electronic device may include a second housing, coupled to the first housing to be slidable with respect to the first housing, including a front cover, and a rear cover disposed on an inner surface of the front cover. According to an embodiment, the electronic device may include a flexible display, disposed on an outer surface of the front cover opposite to the inner surface of the front cover, sliding into or out of the first housing by moving of the second housing. According to an embodiment, the electronic device may include a printed circuit board disposed between the inner surface of the front cover and an inner surface of the rear cover facing the inner surface of the front cover. According to an embodiment, the electronic device may include an air room, disposed in an inside of the first and second housings, expanded or contracted by moving of the second housing. According to an embodiment, the electronic device may include a vent hole penetrating the second housing. According to an embodiment, the electronic device may include an airflow path extending, on an outer surface of the rear cover opposite to the inner surface of the rear cover, from the vent hole to the air room and configured to transmit air introduced from the vent hole to the air room or transmit air within the air room to the vent hole when the second housing moves.

According to an embodiment, an electronic device may include a first housing. According to an embodiment, the electronic device may include a second housing, coupled to the first housing to be slidable with respect to the first housing, including a front cover, a rear cover disposed on the front cover, and a slide cover disposed on the rear cover. According to an embodiment, the electronic device may include a flexible display, disposed on an outer surface of the front cover, sliding into or out of the first housing by moving of the second housing. According to an embodiment, the electronic device may include a printed circuit board disposed on an inner surface of the front cover opposite to the outer surface of the front cover. According to an embodiment, the electronic device may include a battery, spaced apart from the printed circuit board, disposed in the first housing. According to an embodiment, the electronic device may include an air room, disposed between the printed circuit board and the battery, expanded or contracted by moving of the second housing. According to an embodiment, the electronic device may include a vent hole penetrating the front cover. According to an embodiment, the electronic device may include an airflow path extending, between the rear cover and the slide cover, from the vent hole to the air room and configured to transmit air introduced from the vent hole to the air room or transmit air within the air room to the vent hole when the second housing moves.

### [Description of the Drawings]

FIG. 1 is a block diagram illustrating an electronic device in a network environment according to various embodiments.
FIG. 2A is a top plan view of an exemplary electronic device in a first state.
FIG. 2B is a bottom view of an exemplary electronic device in a first state.
FIG. 2C is a top plan view of an exemplary electronic device in a second state.
FIG. 2D is a bottom view of an exemplary electronic device in a second state.
FIG. 3A and FIG. 3B are exploded perspective views of an exemplary electronic device.
FIG. 4A is a cross-sectional view of an exemplary electronic device in a first state.
FIG. 4B is a cross-sectional view of an exemplary electronic device in a second state.
FIG. 5A is a perspective view of an exemplary electronic device in a first state.
FIG. 5B is a perspective view of an exemplary electronic device in a second state.
FIG. 5C is an exploded perspective view of a second housing of an exemplary electronic device.
FIG. 6 is a cross-sectional view illustrating an example in which an exemplary electronic device according to an embodiment is cut along line C-C' of FIG. 5B.
FIG. 7 is a top plan view of a second housing of an exemplary electronic device according to an embodiment.

### [Mode for Invention]

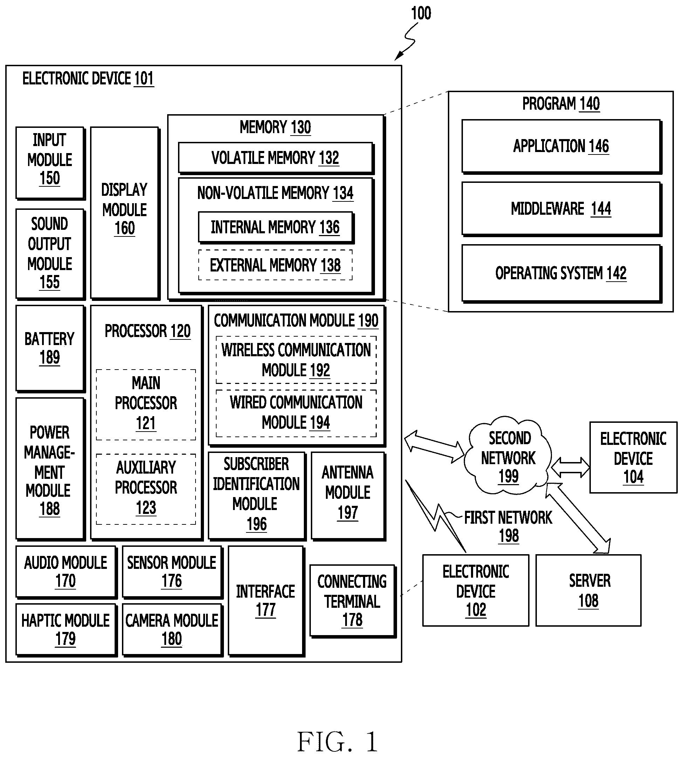

FIG. 1 is a block diagram illustrating an electronic device 101 in a network environment 100 according to various embodiments.

Referring to FIG. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module(SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to an embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, an HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to an embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, an RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adj acent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

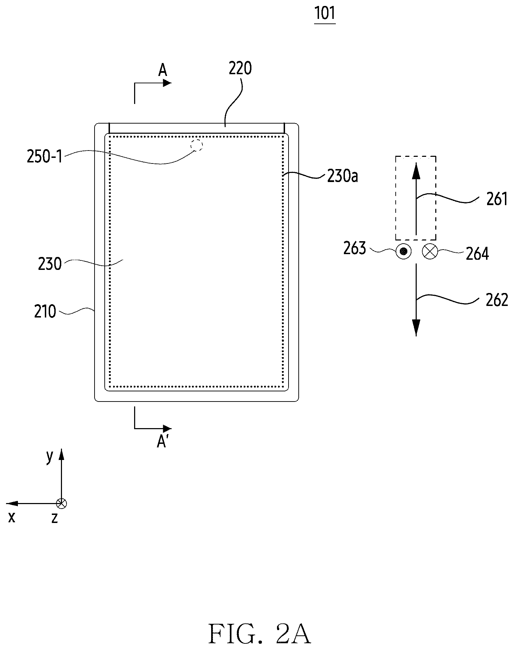

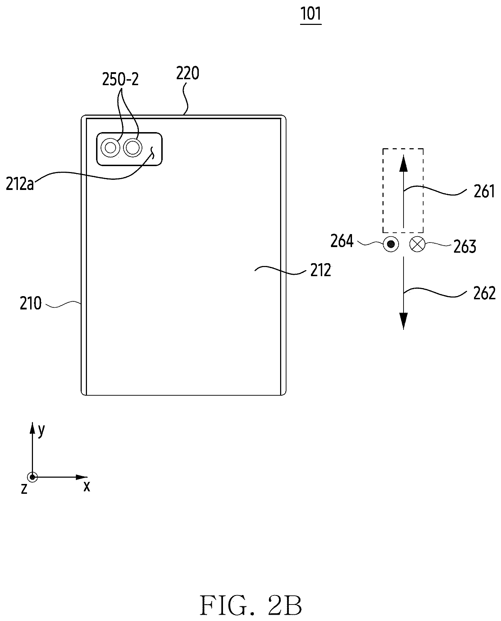

For example, a display of the display module 160 may be flexible. For example, the display may include a display area exposed to an outside of a housing of the electronic device 101 that provides at least a portion of an outer surface of the electronic device 101. For example, since the display has flexibility, at least a portion of the display may be rollable into the housing or may be slidable into the housing. For example, a size of the display area may be changed according to a size of the at least a portion of the display rolled into the housing or slid into the housing. For example, the electronic device 101 including the display may be in a plurality of states including a first state providing the display area having a first size and a second state providing the display area having a second size different from the first size. For example, the first state may be exemplified through a description of FIG. 2A and FIG. 2B.

FIG. 2A is a top plan view of an exemplary electronic device 101 in a first state.

Referring to FIG. 2A, the electronic device 101 may include a first housing 210, a second housing 220 that is movable with respect to the first housing 210 in a first direction 261 parallel to a y-axis, or a second direction 262 parallel to the y-axis and opposite to the first direction 261, and a display 230 (e.g., the display).

For example, the electronic device 101 may be in the first state. For example, in the first state, the second housing 220 may be movable with respect to the first housing 210 in the first direction 261 among the first direction 261 and the second direction 262. For example, in the first state, the second housing 220 may not be movable with respect to the first housing 210 in the second direction 262.

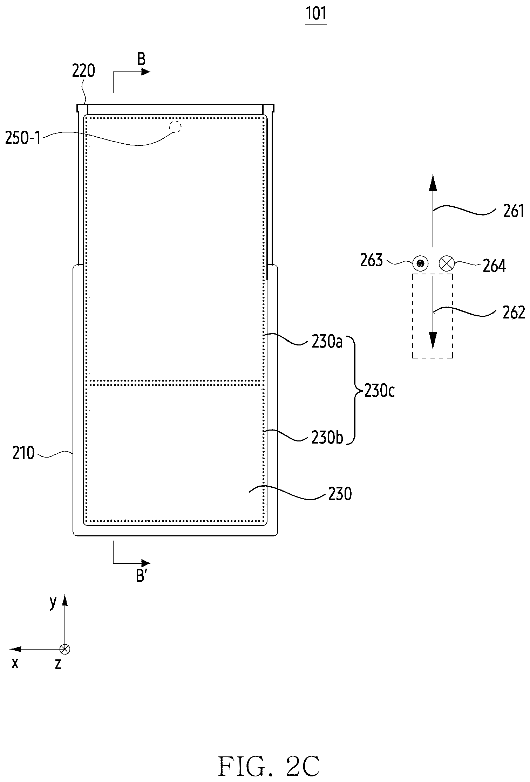

For example, in the first state, the display 230 may provide the display area having the smallest size. For example, in the first state, the display area may correspond to a region 230a. For example, although not illustrated in FIG. 2A, in the first state, a region (e.g., a region 230b of FIG. 2C) of the display 230 different from the region 230a that is the display area may be included in the first housing 210. For example, in the first state, the region may be covered by the first housing 210. For example, in the first state, the region may be rolled into the first housing 210. For example, in the first state, the region 230a may include a planar portion, unlike the region including a curved portion. However, it is not limited thereto. For example, the region 230a may also include the curved portion extending from the planar portion and positioned in an edge portion in the first state.

For example, the first state may be referred to as a slide-in state or a closed state in terms of at least a portion of the second housing 220 being positioned in the first housing 210. For example, the first state may be referred to as a contracted state in terms of providing the display area having the smallest size. However, it is not limited thereto.

For example, the first housing 210 may include a first image sensor 250-1 in a camera module 180 exposed visually through a portion of the region 230a and facing a third direction 263 parallel to a z-axis. For example, the camera module 180 may also be disposed to perform its function without being visually exposed through the portion of the region 230a in an inner space of the electronic device. For example, although not illustrated in FIG. 2A, the second housing 220 may include one or more second image sensors in the camera module 180 exposed through the portion of the second housing 220 and facing a fourth direction 264 parallel to the z-axis and opposite to the third direction 263. For example, the one or more second image sensors may be exemplified through a description of FIG. 2B.

FIG. 2B is a bottom view of an exemplary electronic device in a first state.

Referring to FIG. 2B, in the first state, one or more second image sensors 250-2 disposed in the second housing 220 may be positioned within a structure disposed in the first housing 210 for the one or more second image sensors 250-2. For example, light from an outside of the electronic device 101 may be received to the one or more second image sensors 250-2 through the structure in the first state. For example, since the one or more second image sensors 250-2 are positioned within the structure in the first state, the one or more second image sensors 250-2 may be exposed through the structure in the first state. For example, the structure may be implemented in various ways. For example, the structure may be an opening or a notch. For example, the structure may be an opening 212a in a plate 212 of the first housing 210 surrounding at least a portion of the second housing 220. However, it is not limited thereto. For example, in the first state, the one or more second image sensors 250-2 included in the second housing 220 may be covered by the plate 212 of the first housing 210.

Referring back to FIG. 2A, the first state may be changed to a second state.

For example, the first state (or the second state) may be changed to the second state (or the first state) through one or more intermediate states between the first state and the second state.

For example, the first state (or the second state) may be changed to the second state (or the first state) based on a predefined user input. For example, the first state (or the second state) may be changed to the second state (or the first state) in response to the user input to a physical button exposed through a portion of the first housing 210 or a portion of the second housing 220. For example, the first state (or the second state) may be changed to the second state (or the first state) in response to a touch input to an executable object displayed in the display area. For example, the first state (or the second state) may be changed to the second state (or the first state) in response to the touch input having a contact point on the display area and having pressing strength greater than or equal to reference strength. For example, the first state (or the second state) may be changed to the second state (or the first state) in response to a voice input received through a microphone of the electronic device 101. For example, the first state (or the second state) may be changed to the second state (or the first state) in response to force applied to the first housing 210 and/or the second housing 220 to move the second housing 220 with respect to the first housing 210. For example, the first state (or the second state) may be changed to the second state (or the first state) in response to the user input identified on an external electronic device (e.g., earbuds or a smart watch) connected to the electronic device 101. However, it is not limited thereto.

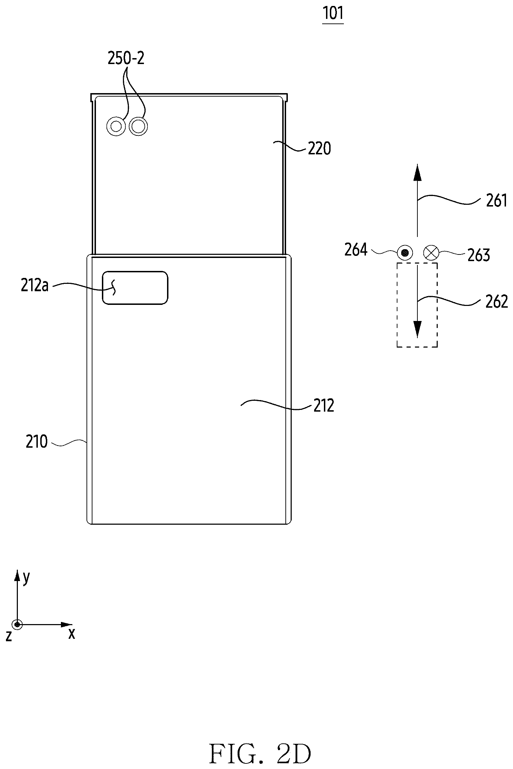

The second state may be exemplified through a description of FIG. 2C and FIG. 2D.

FIG. 2C is a top plan view of an exemplary electronic device in a second state.

Referring to FIG. 2C, the electronic device 101 may be in the second state. For example, in the second state, the second housing 220 may be movable with respect to the first housing 210 in the second direction 262 among the first direction 261 and the second direction 262. For example, in the second state, the second housing 220 may not be movable with respect to the first housing 210 in the first direction 261.

For example, in the second state, the display 230 may provide the display area having the largest size. For example, in the second state, the display area may correspond to a region 230c including the region 230a and the region 230b. For example, the region 230b that was included in the first housing 210 in the first state may be exposed in the second state. For example, in the second state, the region 230a may include the planar portion. However, it is not limited thereto. For example, the region 230a may also include the curved portion extending from the planar portion and positioned in the edge portion. For example, in the second state, the region 230b, unlike the region 230a in the first state, may include the planar portion among the planar portion and the curved portion. However, it is not limited thereto. For example, the region 230b may also include the curved portion extending from the planar portion of the region 230b and positioned in the edge portion.

For example, the second state may be referred to as a slide-out state or an open state in terms of at least a portion of the second housing 220 being positioned in an outside the first housing 210. For example, the second state may be referred to as an expanded state in terms of providing the display area having the largest size. However, it is not limited thereto.

For example, when the state of the electronic device 101 is changed from the first state to the second state, the first image sensor 250-1 facing the third direction 263 may move together with the region 230a according to moving of the second housing 220 in the first direction 261. For example, although not illustrated in FIG. 2C, when the state of electronic device 101 is changed from the first state to the second state, the one or more second image sensors 250-2 facing the fourth direction 264 may be moved according to the moving of the second housing 220 in the first direction 261. For example, a relative positional relationship between the one or more second image sensors 250-2 and the structure exemplified through the description of FIG. 2B may be changed according to the moving of the one or more second image sensors 250-2. For example, the change in the relative positional relationship may be exemplified through FIG. 2D.

FIG. 2D is a bottom view of an exemplary electronic device 101 in a second state.

Referring to FIG. 2D, in the second state, the one or more second image sensors 250-2 may be positioned outside the structure. For example, in the second state, the one or more second image sensors 250-2 may be positioned outside the opening 212a in the plate 212. For example, since the one or more second image sensors 250-2 are positioned outside the opening 212a in the second state, the one or more second image sensors 250-2 may be exposed in the second state. For example, since the one or more second image sensors 250-2 are positioned outside the structure in the second state, the relative positional relationship in the second state may be different from the relative positional relationship in the first state.

For example, in case that the electronic device 101 does not include the structure such as the opening 212a, the one or more second image sensors 250-2 in the second state may be exposed, unlike the one or more second image sensors 250-2 in the first state.

Although not illustrated in FIG. 2A, FIG. 2B, FIG. 2C, and FIG. 2D, the electronic device 101 may be in the intermediate state between the first state and the second state. For example, the size of the display area in the intermediate state may be larger than the size of the display area in the first state and smaller than the size of the display area in the second state. For example, the display area in the intermediate state may correspond to a region including a portion of the region 230a and the region 230b. For example, in the intermediate state, the portion of the region 230b may be exposed, and another portion (or a remaining portion) of the region 230b may be covered by the first housing 210 or rolled into the first housing 210. However, it is not limited thereto.

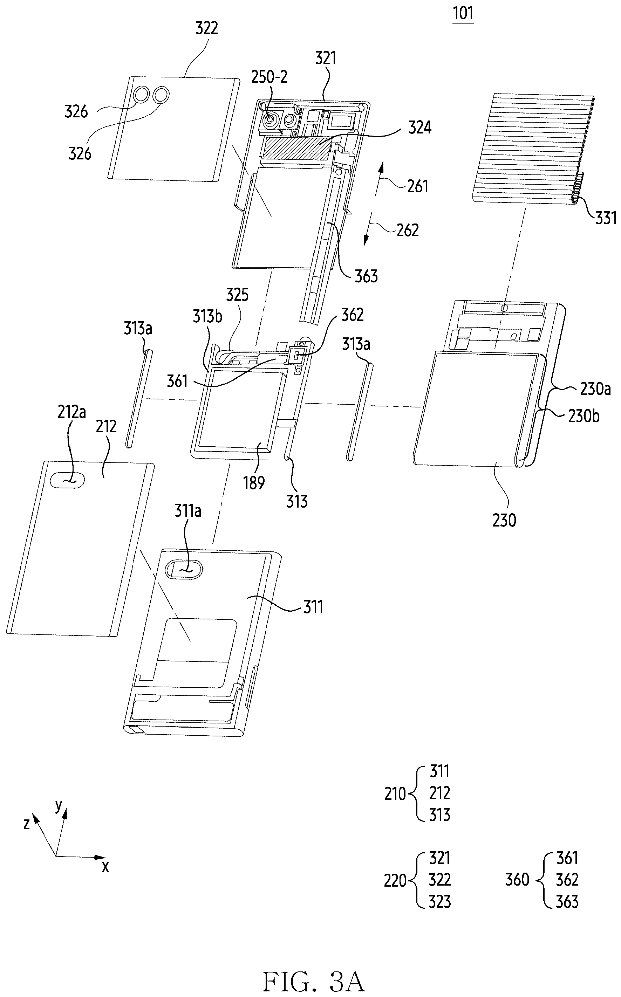

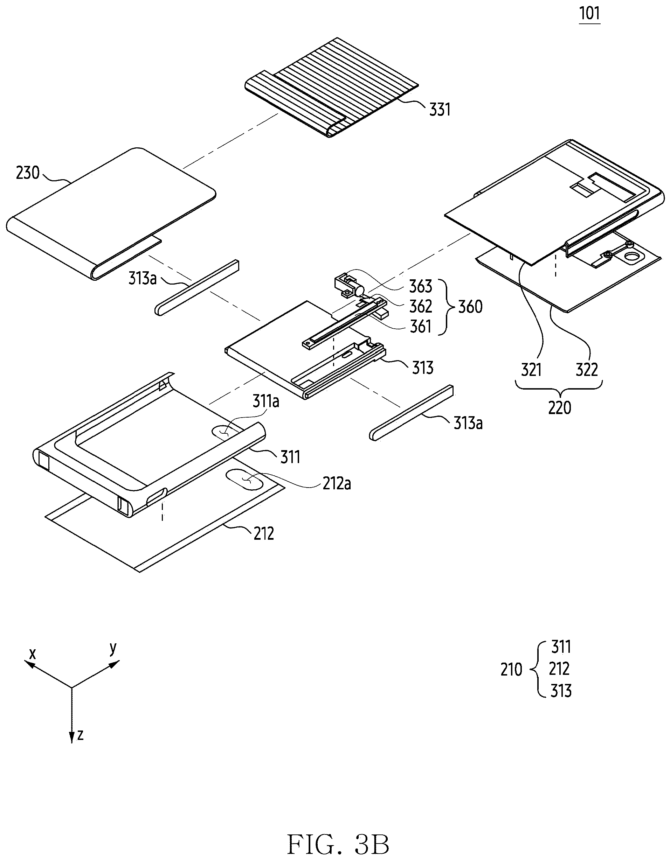

Referring back to FIG. 1, the electronic device 101 may include structures for moving the second housing (e.g., the second housing 220 of FIG. 2) of the electronic device 101 with respect to the first housing (e.g., the first housing 210 of FIG. 2) of the electronic device 101. For example, the structures may be exemplified through a description of FIG. 3A and FIG. 3B.

FIG. 3A and FIG. 3B are exploded perspective views of an exemplary electronic device.

Referring to FIG. 3A and FIG. 3B, the electronic device 101 may include a first housing 210, a second housing 220, a display 230, and a driving unit 360.

For example, the first housing 210 may include a book cover 311, a plate 212, and a frame cover 313.

For example, the book cover 311 may at least partially form a lateral surface portion of an outer surface of the electronic device 101. For example, the book cover 311 may at least partially form a rear portion of the outer surface. For example, the book cover 311 may include an opening 311a for one or more second image sensors 250-2. For example, the book cover 311 may include a surface supporting the plate 212. For example, the book cover 311 may be coupled to the plate 212. For example, the book cover 311 may include the frame cover 313. For example, the book cover 311 may be coupled to the frame cover 313.

For example, the plate 212 may at least partially form the rear portion of the outer surface. For example, the plate 212 may include an opening 212a for the one or more second image sensors 250-2. For example, the plate 212 may be disposed on the surface of the book cover 311. For example, the opening 212a may be aligned with the opening 311a.

For example, the frame cover 313 may be at least partially surrounded by the book cover 311.

For example, the frame cover 313 may be at least partially surrounded by the display 230. For example, the frame cover 313 may be at least partially surrounded by the display 230, but a position of the frame cover 313 may be maintained independently of moving of the display 230. For example, the frame cover 313 may be arranged in relation to at least a portion of components of the display 230. For example, the frame cover 313 may include rails 313a that provide (or guide) a moving path of at least one component of the display 230.

For example, the frame cover 313 may be coupled to at least one component of the electronic device 101. For example, the frame cover 313 may support a rechargeable battery 189. For example, the battery 189 may be supported through a recess or a hole in a surface 313b of the frame cover 313. For example, the frame cover 313 may be coupled to an end of a flexible printed circuit board (FPCB) 325 on the surface of the frame cover 313. For example, although not explicitly illustrated in FIG. 3A and FIG. 3B, another end of the FPCB 325 may be connected to a PCB 324 through at least one connector. For example, the PCB 324 may be electrically connected to another PCB (not illustrated in FIG. 3A and FIG. 3B) that supplies power to a motor 361 through the FPCB 325.

For example, the frame cover 313 may be coupled to at least one structure of the electronic device 101 for a plurality of states including the first state and the second state. For example, the frame cover 313 may fasten the motor 361 of the driving unit 360.

For example, the second housing 220 may include a front cover 321 and a slide cover 322.

For example, the front cover 321 may be at least partially surrounded by the display 230. For example, the front cover 321 may be coupled to at least a portion of a region 230a of the display 230 surrounding the front cover 321, unlike the frame cover 313, so that the display 230 moves along the second housing 220 that moves with respect to the first housing 210.

For example, the front cover 321 may be coupled to at least one component of the electronic device 101. For example, the front cover 321 may be coupled to the printed circuit board (PCB) 324 including the components of the electronic device 101. For example, the PCB 324 may include a processor 120 (not illustrated in FIG. 3A and FIG. 3B). For example, the front cover 321 may include the one or more second image sensors 250-2.

For example, the front cover 321 may be coupled to at least one structure of the electronic device 101 for the plurality of states including the first state and the second state. For example, the front cover 321 may fasten a rack gear 363 of the driving unit 360.

For example, the front cover 321 may be coupled to the slide cover 322.

For example, the slide cover 322 may be coupled to the front cover 321 to protect at least one component of the electronic device 101 coupled in the front cover 321 and/or at least one structure of the electronic device 101 coupled in the front cover 321. For example, the slide cover 322 may include the structure for the at least one component. For example, the slide cover 322 may include one or more openings 326 for the one or more second image sensors 250-2. For example, the one or more openings 326 may be aligned with the one or more second image sensors 250-2 disposed on the front cover 321. For example, a size of each of the one or more openings 326 may correspond to a size of each of the one or more second image sensors 250-2.

For example, the display 230 may include a support member 331. For example, the support member 331 may include a plurality of bars. For example, the plurality of bars may be coupled to each other.

For example, the driving unit 360 may include the motor 361, a pinion gear 362, and the rack gear 363.

For example, the motor 361 may operate based on power from the battery 189. For example, the power may be provided to the motor 361, in response to a predefined user input.

For example, the pinion gear 362 may be coupled to the motor 361 through a shaft. For example, the pinion gear 362 may be rotated, based on the operation of the motor 361 transmitted through the shaft.

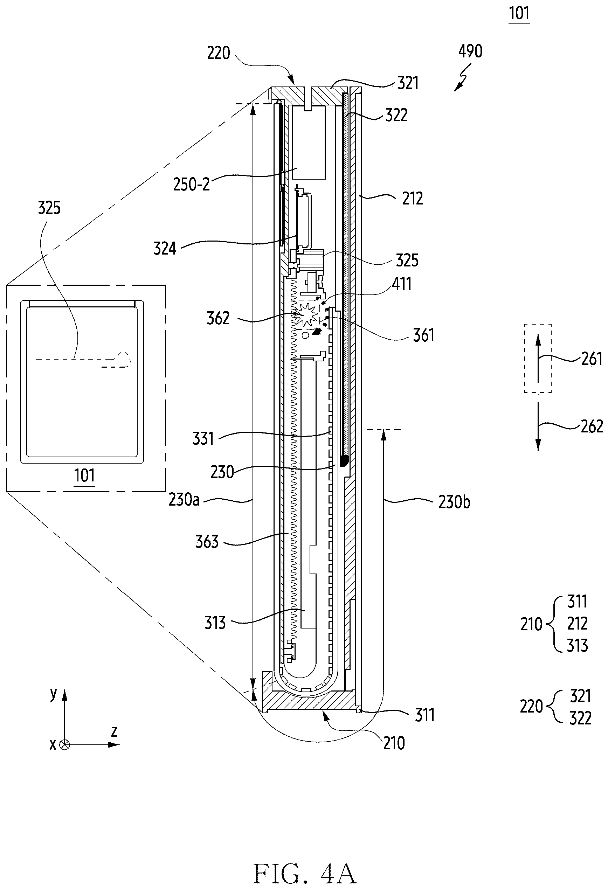

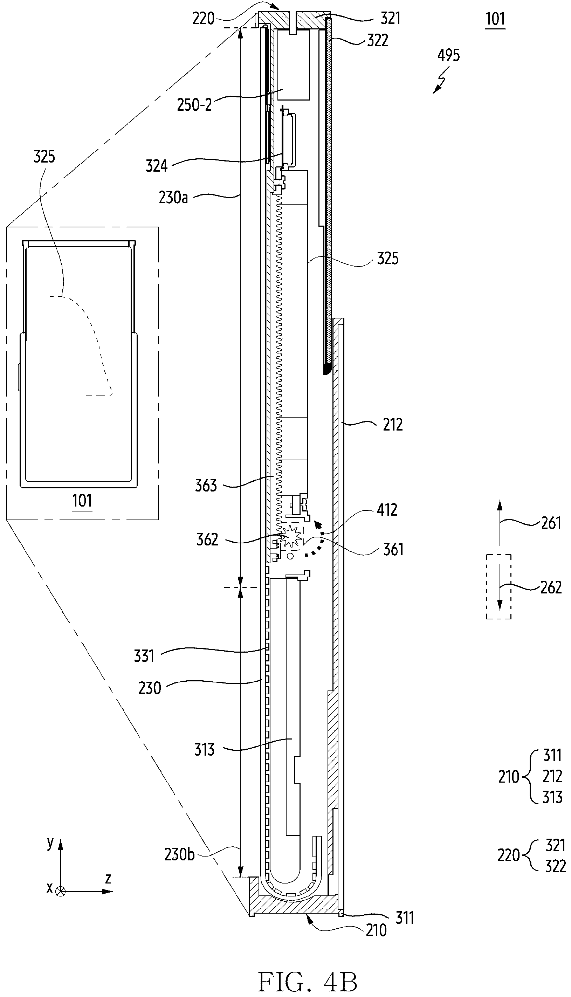

For example, the rack gear 363 may be arranged in relation to the pinion gear 362. For example, teeth of the rack gear 363 may be engaged with teeth of the pinion gear 362. For example, the rack gear 363 may be moved in a first direction 261 or a second direction 262 according to rotation of the pinion gear 362. For example, the second housing 220 may be moved in the first direction 261 and the second direction 262 by the rack gear 363 that is moved according to the rotation of the pinion gear 362 due to the operation of the motor 361. For example, the first state of the electronic device 101 may be changed to a state (e.g., the one or more intermediate states or the second state) different from the first state through the moving of the second housing 220 in the first direction 261. For example, the second state of the electronic device 101 may be changed to a state (e.g., the one or more intermediate states or the first state) different from the second state through the moving of the second housing 220 in the second direction 262. For example, it may be exemplified through FIG. 4A and FIG. 4B that the first state is changed to the second state by the driving unit 360 and that the second state is changed to the first state by the driving unit 360.

FIG. 4A is a cross-sectional view of an exemplary electronic device in a first state. FIG. 4B is a cross-sectional view of an exemplary electronic device in a second state.

Referring to FIG. 4A and FIG. 4B, a motor 361 may be operated, based at least in portion on the predefined user input received in a state 490 which is the first state. For example, a pinion gear 362 may be rotated in a first rotation direction 411 based at least in portion on the operation of the motor 361. For example, a rack gear 363 may be moved in a first direction 261 based at least in portion on the rotation of the pinion gear 362 in the first rotation direction 411. For example, since a front cover 321 in a second housing 220 fastens the rack gear 363, the second housing 220 may be moved in the first direction 261, based at least in portion on the moving of the rack gear 363 in the first direction 261. For example, since the front cover 321 in the second housing 220 is coupled to at least a portion of a region 230a of a display 230 and fastens the rack gear 363, the display 230 may be moved, based at least in portion on the moving of the rack gear 363 in the first direction 261. For example, the display 230 may be moved along rails 313a. For example, a shape of at least a portion of the plurality of bars of a support member 331 of the display 230 may be changed when the state 490 is changed to a state 495 which is the second state.

For example, a region 230b of the display 230 may be moved according to the moving of the display 230. For example, when the state 490 is changed to the state 495 according to the predefined user input, the region 230b may be moved through a space between a book cover 311 and a frame cover 313. For example, the region 230b in the state 495 may be exposed, unlike the region 230b rolled into the space in the state 490.

For example, since the front cover 321 in the second housing 220 is coupled to a PCB 324 connected to the other end of an FPCB 325 and fastens the rack gear 363, a shape of the FPCB 325 may be changed when the state 490 is changed to the state 495.

The motor 361 may be operated, based at least in portion on the predefined user input received in the state 495. For example, the pinion gear 362 may be rotated in a second rotation direction 412, based at least in portion on the operation of the motor 361. For example, the rack gear 363 may be moved in a second direction 262, based at least in portion on the rotation of the pinion gear 362 in the second rotation direction 412. For example, since the front cover 321 in the second housing 220 fastens the rack gear 363, the second housing 220 may be moved in the second direction 262, based at least in portion on the moving of the rack gear 363 in the second direction 262. For example, since the front cover 321 in the second housing 220 is coupled to at least a portion of the region 230a of the display 230 and fastens the rack gear 363, the display 230 may be moved, based at least in portion on the moving of the rack gear 363 in the second direction 262. For example, the display 230 may be moved along the rails 313a. For example, the shape of at least a portion of the plurality of bars of the support member 331 of the display 230 may be changed when the state 495 is changed to the state 490.

For example, the region 230b of the display 230 may be moved according to the moving of the display 230. For example, when the state 495 is changed to the state 490 according to the predefined user input, the region 230b may be moved through the space between the book cover 311 and the frame cover 313. For example, the region 230b in the state 490 may be rolled into the space, unlike the region 230b exposed in the state 495.

For example, since the front cover 321 in the second housing 220 is coupled to the PCB 324 connected to the other end of the FPCB 325 and fastens the rack gear 363, the shape of the FPCB 325 may be changed when the state 495 is changed to the state 490.

FIG. 2A to FIG. 4B illustrate the electronic devices 101 in which height of the display area is changed and width of the display area is maintained when the first state (or the second state) is changed to the second state (or the first state) in a portrait mode, but this is for convenience of description. For example, the electronic device 101 may be implemented such that the height of the display area is maintained and the width of the display area is changed when the first state (or the second state) is changed to the second state (or the first state) in the portrait mode.

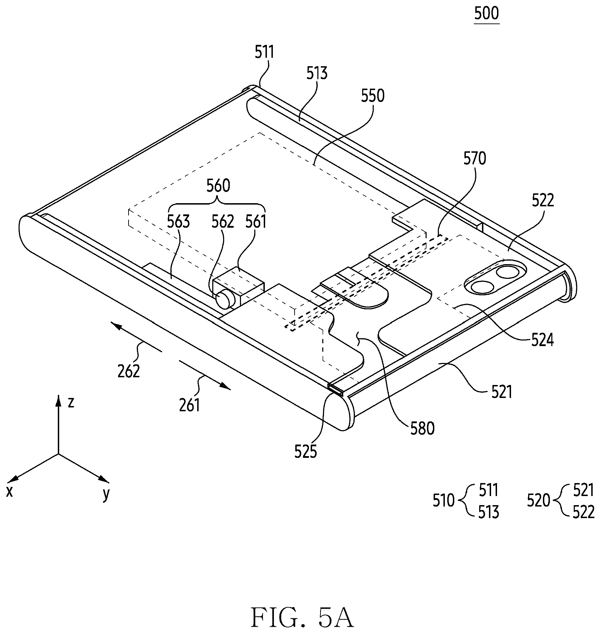

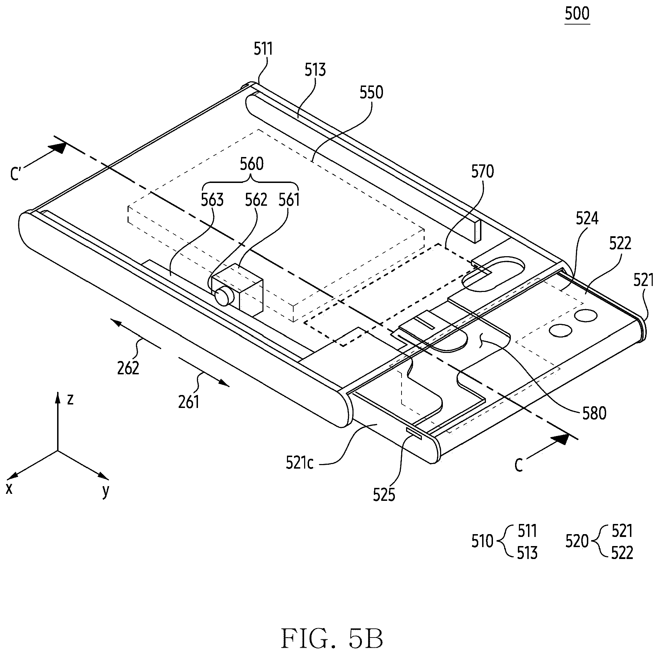

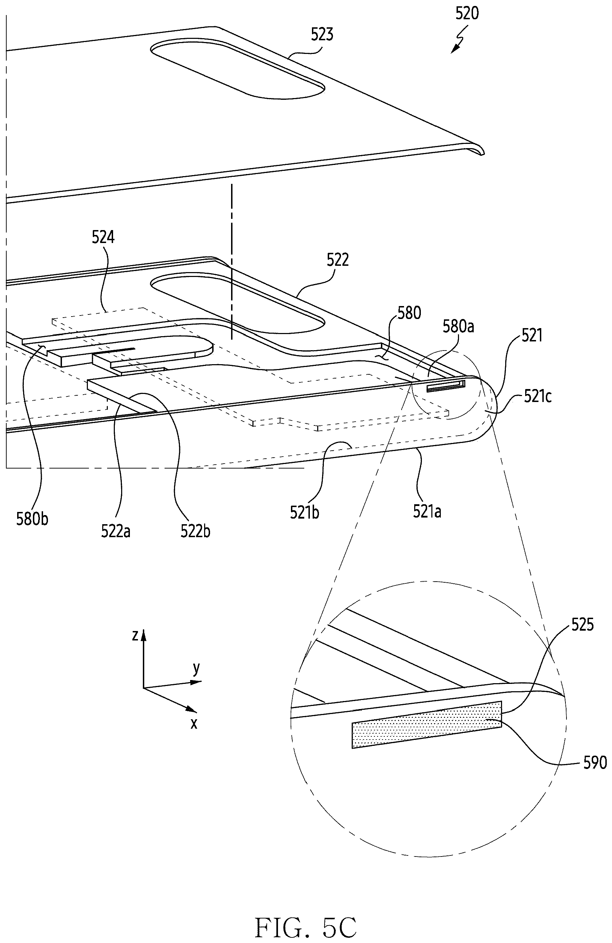

FIG. 5A is a perspective view of an exemplary electronic device in a first state, FIG. 5B is a perspective view of an exemplary electronic device in a second state, and FIG. 5C is an exploded perspective view of a second housing of an exemplary electronic device.

FIG. 5A and FIG. 5B illustrate an example of a state in which a slide cover 523 is removed from a second housing 520, and FIG. 5C illustrates an example in which the slide cover 523 is coupled to a rear cover 522.

Referring to FIG. 5A, FIG. 5B, and FIG. 5C, an electronic device 500 (e.g., the electronic device 101 of FIG. 1, FIG. 2A, FIG. 2B, FIG. 2C, FIG. 2D, FIG. 3A, FIG. 3B, FIG. 4A, and FIG. 4B) according to an embodiment may include a first housing 510 (e.g., the first housing 210 of FIG. 2A, FIG. 2B, FIG. 2C, FIG. 2D, FIG. 3A, FIG. 3B, FIG. 4A, and FIG. 4B), a second housing 520 (e.g., the second housing 220 of FIG. 2A, FIG. 2B, FIG. 2C, FIG. 2D, FIG. 3A, FIG. 3B, FIG. 4A, and FIG. 4B), a battery 550 (e.g., the battery 189 of FIG. 1 and FIG. 3A), a driving unit 560 (e.g., the driving unit 360 of FIG. 3A, FIG. 3B, FIG. 4A, and FIG. 4B), an air room 570, an airflow path 580, and/or a blocking member 590. According to an embodiment, the electronic device 500 may be referred to as a rollable device viewed from a lateral surface in which a size of a display (e.g., the display 230 of FIG. 2A, FIG. 2B, FIG. 2C, FIG. 2D, FIG. 3A, FIG. 3B, FIG. 4A, and FIG. 4B) visible from an outside of the electronic device 500 may be changed.

According to an embodiment, the first housing 510 may define at least a portion of an outer surface of the electronic device 500. The first housing 510 may support components in the electronic device 500. The first housing 510 may define a space in which the components in the electronic device 500 may be mounted. For example, the first housing 510 may include a book cover 511 (e.g., the book cover 311 of FIG. 3A, FIG. 3B, FIG. 4A, and FIG. 4B), and a frame cover 513 (e.g., the frame cover 313 of FIG. 3A, FIG. 3B, FIG. 4A, and FIG. 4B). The book cover 511 may define an outer surface of the first housing 510. The frame cover 513 may be disposed in the book cover 511. For example, the frame cover 513 may be surrounded by the book cover 511. The frame cover 513 may support the components in the electronic device 500. For example, the frame cover 513 may support the battery 550 and the driving unit 560 in the book cover 511.

According to an embodiment, the second housing 520 may define an inner space of the electronic device 500 together with the first housing 510. The second housing 520 may be movable with respect to the first housing 510. For example, the second housing 520 may be coupled to the first housing 510 to be slidable with respect to the first housing 510. The second housing 520 may slide inside the first housing 510 or slide outside the first housing 510. According to an embodiment, the second housing 520 may be movable in a first direction 261 (e.g., +y direction), and/or in a second direction 262 (e.g., -y direction) opposite to the first direction 261. In a first state of the electronic device 500, the second housing 520 may be movable only in the first direction 261 among the first direction 261 and the second direction 262. In a second state of the electronic device 500, the second housing 520 may be movable only in the second direction 262 among the first direction 261 and the second direction 262. For example, the second housing 520 may slide outside the first housing 510 as the second housing 520 moves in the first direction 261. For example, the second housing 520 may slide inside the first housing 510 as the second housing 520 moves in the second direction 262.

According to an embodiment, the second housing 520 may support the components of the electronic device 500. For example, a display 230 may be disposed on a surface of the second housing 520. When the second housing 520 moves, the display 230 may move together with the second housing 520. For example, the display 230 may slide inside the first housing 510 or outside the first housing 510, by moving of the second housing 520. For example, the display 230 may slide inside the book cover 511 of the first housing 510 or slide outside the book cover 511 of the first housing 510 by the moving of the second housing 520. For example, as the second housing 520 moves in the first direction 261, the display 230 may slide outside the first housing 510. For example, as the second housing 520 moves in the second direction 262, the display 230 may slide inside the first housing 510.

Referring to FIG. 5C, the second housing 520 according to an embodiment may include a front cover 521 (e.g., the front cover 321 of FIG. 3A, FIG. 3B, FIG. 4A, and FIG. 4B), the rear cover 522, and/or the slide cover 523 (e.g., the slide cover 322 of FIG. 3A, FIG. 3B, FIG. 4A, and FIG. 4B).

According to an embodiment, the front cover 521 may support the components of the electronic device 500. For example, the display 230 may be disposed on an outer surface 521a of the front cover 521. For example, a printed circuit board 524 (e.g., the PCB 234 of FIG. 3A, FIG. 4A, and FIG. 4B) may be disposed on an inner surface 521b of the front cover 521 opposite to the outer surface 521a of the front cover 521. For example, the printed circuit board 524 may include a processor (e.g., the processor 120 of FIG. 1) disposed on the printed circuit board 524. For example, the printed circuit board 524 may be referred to as a main PCB in terms of including electronic components including various functional implementations of the electronic device 500. A direction (e.g., -z direction) in which the outer surface 521a of the front cover 521 faces may be opposite to a direction (e.g., +z direction) in which the inner surface 521b of the front cover 521 faces. The outer surface 521a of the front cover 521 may be spaced apart from the inner surface 521b of the front cover 521. According to an embodiment, the outer surface 521a of the front cover 521 may be parallel to the inner surface 521b of the front cover 521. According to an embodiment, a portion of the front cover 521 may be opened. According to an embodiment, a lateral surface 521c of the front cover 521 perpendicular to the outer surface 521a of the front cover 521 may define a portion of an outer surface of the second housing 520. For example, the lateral surface 521c of the front cover 521 perpendicular to the outer surface 521a of the front cover 521 may be exposed to the outside of the electronic device 500 in the first state of the electronic device 500. For example, the lateral surface 521c of the front cover 521 may be covered by the book cover 511 of the first housing 510 in the second state of the electronic device 500.

According to an embodiment, the rear cover 522 may be coupled to the front cover 521. For example, the rear cover 522 may be coupled to the portion of the open front cover 521. The rear cover 522 may be disposed on the inner surface 521b of the front cover 521. For example, the rear cover 522 may be spaced apart from the inner surface 521b of the front cover 521 in the direction (e.g., +z direction) in which the inner surface 521b of the front cover 521 faces. An inner surface 522a of the rear cover 522 faces the inner surface 521b of the front cover 521 and may be spaced apart from the inner surface 521b of the front cover 521. A direction (e.g., -z direction) in which the inner surface 522a of the rear cover 522 faces may be opposite to the direction (e.g., +z direction) in which the inner surface 521b of the front cover 521 faces. An outer surface 522b of the rear cover 522 may be opposite to the inner surface 522a of the rear cover 522. A direction (e.g., +z direction) in which the outer surface 522b of the rear cover 522 faces may be opposite to the direction (e.g., -z direction) in which the inner surface 522a of the rear cover 522 faces. The outer surface 522b of the rear cover 522 may be spaced apart from the inner surface 522a of the rear cover 522.

According to an embodiment, the slide cover 523 may be coupled to the rear cover 522. For example, the slide cover 523 may be disposed on the outer surface 522b of the rear cover 522 opposite to the inner surface 522a of the rear cover 522. The slide cover 523 may cover the airflow path 580 by being disposed on the outer surface 522b of the rear cover 522. According to an embodiment, the slide cover 523 may define another portion of the outer surface of the second housing 520. For example, the outer surface of the slide cover 523 may define another portion of the outer surface of the second housing 520 by being exposed to the outside of the electronic device 500.

According to an embodiment, as the second housing 520 moves, at least a portion of the second housing 520 may be exposed to an outside of the first housing 510. As the second housing 520 moves, at least a portion of the second housing 520 may be covered by the first housing 510. For example, as the second housing 520 moves, the front cover 521, the rear cover 522, and/or the slide cover 523 may be covered by the book cover 511 of the first housing 510. For example, as the second housing 520 moves, the front cover 521, the rear cover 522, and/or the slide cover 523 may be exposed to an outside of the book cover 511 of the first housing 510.

According to an embodiment, the battery 550 may be configured to supply power to the components in the electronic device 500. For example, the battery 550 may be configured to be electrically connected to the printed circuit board 524 disposed in the second housing 520 and supply power to the electronic components disposed on the printed circuit board 524. According to an embodiment, the battery 550 may be disposed in the first housing 510. For example, the battery 550 may be disposed in the frame cover 513 of the first housing 510. The battery 550 may be spaced apart from the printed circuit board 524. A distance between the battery 550 and the printed circuit board 524 may be changed by the moving of the second housing 520 with respect to the first housing 510. For example, as the second housing 520 moves in the first direction 261, the distance between the battery 550 and the printed circuit board 524 may increase. For example, as the second housing 520 moves in the second direction 262, the distance between the battery 550 and the printed circuit board 524 may decrease.

According to an embodiment, the driving unit 560 may provide driving force to the second housing 520 so that the second housing 520 is movable with respect to the first housing 510. The driving unit 560 may include a motor 561 (e.g., the motor 361 of FIG. 3A, FIG. 3B, FIG. 4A, and FIG. 4B), a pinion gear 562 (e.g., the pinion gear 362 of FIG. 3A, FIG. 3B, FIG. 4A, and FIG. 4B), and/or a rack gear 563 (e.g., the rack gear 363 of FIG. 3A, FIG. 3B, FIG. 4A, and FIG. 4B). The motor 561 may be disposed in the first housing 510. For example, the motor 561 may be supported by the frame cover 513. The motor 561 may be driven based on the power received from the battery 550 by being electrically connected to the battery 550. The pinion gear 562 may be coupled to the motor 561 to be rotatable with respect to the motor 561. The pinion gear 562 may be disposed on the frame cover 513 of the first housing 510. The rack gear 563 may be disposed in the second housing 520. For example, the rack gear 563 may be disposed on the inner surface 521b of the front cover 521. The rack gear 563 is engaged with the pinion gear 562 and may move by rotation of the pinion gear 562. By the moving of the rack gear 563, the second housing 520 coupled to the rack gear 563 may move.

The air room 570 may be defined in an inside of the electronic device 500. According to an embodiment, the air room 570 may be disposed in an inside of the first housing 510 and the second housing 520. For example, the air room 570 may be disposed between the battery 550 disposed in the first housing 510 and the printed circuit board 524 disposed in the second housing 520. For example, the air room 570 may be disposed between the motor 561 disposed in the first housing 510 and the printed circuit board 524 disposed in the second housing 520. According to an embodiment, the air room 570 may be expanded or contracted by the moving of the second housing 520 with respect to the first housing 510. For example, when the second housing 520 moves in the first direction 261, a size of the air room 570 may be expanded. For example, when the second housing 520 moves in the second direction 262, the size of the air room 570 may be reduced.

According to an embodiment, the second housing 520 may include a vent hole 525 penetrating the second housing 520. For example, the vent hole 525 may penetrate the lateral surface 521c of the front cover 521. The vent hole 525 may connect an outside of the second housing 520 and an inside of the second housing 520. The vent hole 525 may introduce air into the electronic device 500 or flow out air in the electronic device 500. For example, when the second housing 520 moves in the first direction 261, air of the outside of the electronic device 500 may be introduced into the air room 570 through the vent hole 525. For example, when the second housing 520 moves in the second direction 262, the air within the air room 570 may be flowed out to the outside of the electronic device 500 through the vent hole 525. For example, in case that the vent hole 525 is not formed, when the second housing 520 moves in the first direction 261, the air room 570 may be expanded. As air pressure in the air room 570 is decreased by expansion of the air room 570, the air within the air room 570 may interfere with the moving of the second housing 520 in the first direction 261. For example, in case that the vent hole 525 is not formed, when the second housing 520 moves in the second direction 262, the air room 570 may be contracted. As the air pressure in the air room 570 is increased by contraction of the air room 570, the air within the air room 570 may interfere with the moving of the second housing 520 in the second direction 262. The electronic device 500 according to an embodiment may provide a structure in which moving of the second housing 520 with respect to the first housing 510 is smooth through the vent hole 525 penetrating the second housing 520. For example, when the second housing 520 moves with respect to the first housing 510, compression or expansion of the air within the air room 570 may be decreased because the air may be introduced into or out of the air room 570 through the vent hole 525. As the compression or expansion of the air within the air room 570 is decreased, moving of the second housing 520 with respect to the first housing 510 may become smooth.

According to an embodiment, an area of the vent hole 525 exposed to the outside of the electronic device 500 may be changed according to the moving of the second housing 520 with respect to the first housing 510. The vent hole 525 may be covered by the first housing 510 in the first state of the electronic device 500. The vent hole 525 may be covered by the book cover 511 of the first housing 510 in the first state of the electronic device 500. For example, when the second housing 520 moves in the first direction 261, the area of the vent hole 525 exposed to the outside of the first housing 510 may increase. The vent hole 525 may be exposed to the outside of the first housing 510 in the second state of the electronic device 500. The vent hole 525 may be exposed to the outside of the book cover 511 of the first housing 510 in the second state of the electronic device 500. For example, when the second housing 520 moves in the second direction 262, the area of the vent hole 525 exposed to the outside of the first housing 510 may be decreased. For example, in case that the vent hole 525 is always exposed to the outside of the electronic device 500, a foreign substance may be introduced into the inside of the first housing 510 and/or the second housing 520 through the vent hole 525. The foreign substance introduced into the inside of the first housing 510 and/or the second housing 520 may damage the components in the electronic device 500. The electronic device 500 according to an embodiment may provide a structure capable of reducing inflow of the foreign substance into the electronic device 500, since the vent hole 525 may be covered by the first housing 510 or exposed to the outside of the first housing 510 according to the moving of the second housing 520.

The airflow path 580 may connect the vent hole 525 and the air room 570. According to an embodiment, the airflow path 580 may be configured to transmit the air introduced from the vent hole 525 to the air room 570 when the second housing 520 moves. The airflow path 580 may be configured to transmit the air within the air room 570 to the vent hole 525 when the second housing 520 moves. According to an embodiment, when the size of the air room 570 is expanded by the moving of the second housing 520, the airflow path 580 may transmit the air introduced from the vent hole 525 to the air room 570. For example, the airflow path 580 may transmit the air introduced from the vent hole 525 to the air room 570 when the second housing 520 moves in the first direction 261. According to an embodiment, when the size of the air room 570 is contracted by the moving of the second housing 520, the airflow path 580 may transmit the air within the air room 570 to the vent hole 525. For example, when the second housing 520 moves in the second direction 262, the air flow path 580 may transmit the air within the air room 570 to the vent hole 525.

According to an embodiment, the airflow path 580 may transmit heat generated in the electronic device 500 to the outside of the electronic device 500. For example, at least a portion of the airflow path 580 may overlap the printed circuit board 524 when the second housing 520 is viewed from above (e.g., in -z direction). For example, as various electronic components are disposed in the printed circuit board 524, heat may be generated from the printed circuit board 524. In case that the heat generated from the printed circuit board 524 is not emitted to the outside of the electronic device 500, the heat may be transmitted to a user gripping the electronic device 500 or transmitted to the electronic components in the electronic device 500, causing performance degradation of the electronic device 500. In case that the electronic device 500 includes another component (e.g., a fan) for emitting the heat generated in the electronic device 500, portability of the electronic device 500 may be decreased since a size of the electronic device 500 may increase. The electronic device 500 according to an embodiment may provide a structure in which the heat generated in the electronic device 500 is emitted to the outside while miniaturizing the electronic device 500 by the airflow path 580 overlapping the printed circuit board 524. For example, since the airflow path 580 that guides moving of airflow generated by the moving of the second housing 520 overlaps the printed circuit board 524, the electronic device 500 may provide the structure capable of emitting the heat generated in the electronic device 500 to the outside of the electronic device 500 without separate components.

According to an embodiment, the airflow path 580 may extend on the outer surface 522b of the rear cover 522. For example, the slide cover 523 disposed on the outer surface 522b of the rear cover 522 may cover the airflow path 580. For example, the airflow path 580 may extend from the vent hole 525 to the air room 570 on the outer surface 522b of the rear cover 522. An end 580a of the airflow path 580 may be connected to the vent hole 525. Another end 580b of the airflow path 580 opposite to an end 580a of the airflow path 580 may extend to an end of the rear cover 522. According to an embodiment, the airflow path 580 may be defined by a portion of the rear cover 522 indented toward an inside of the rear cover 522. For example, the airflow path 580 may be defined by the portion of the rear cover 522 indented in a direction facing the inner surface 522a of the rear cover 522. According to an embodiment, the airflow path 580 may be disposed in a space distinguished from an inner space of the second housing 520 in which the printed circuit board 524 is disposed. For example, in case that the airflow path 580 passes directly through the printed circuit board 524, a size of the airflow path 580 may correspond to a size of the entire rear cover 522. In case that the size of the airflow path 580 corresponds to the size of the entire rear cover 522, inflow or outflow of the air through the airflow path 580 may not be smooth due to an increase in the size of the airflow path 580. The electronic device 500 according to an embodiment may provide a structure in which inflow or outflow of the air into the electronic device 500 is smooth by the airflow path 580 disposed on the outer surface 522b of the rear cover 522.

The blocking member 590 may be configured to block the inflow of the foreign substance through the vent hole 525. For example, the blocking member 590 may be made of waterproof material for blocking the inflow of moisture through the vent hole 525. For example, the waterproof material may include gore-tex, but is not limited thereto. According to an embodiment, the blocking member 590 may be disposed on the vent hole 525. For example, the blocking member 590 may include a plurality of holes to allow the air to move through the vent hole 525. The blocking member 590 may be referred to as a grid in terms of including the plurality of holes. However, it is not limited thereto, and according to embodiments, the blocking member 590 may include a hole to allow the air to move through the vent hole 525.

As described above, the electronic device 500 according to an embodiment may provide the structure in which the second housing 520 moves smoothly with respect to the first housing 510 through the vent hole 525 exposed to the outside of the first housing 510 or covered by the first housing 510. The electronic device 500 according to an embodiment may provide the structure capable of emitting the heat generated in the electronic device 500 by the airflow path 580 that guides the moving of air into the inside or out to the outside of the electronic device 500.

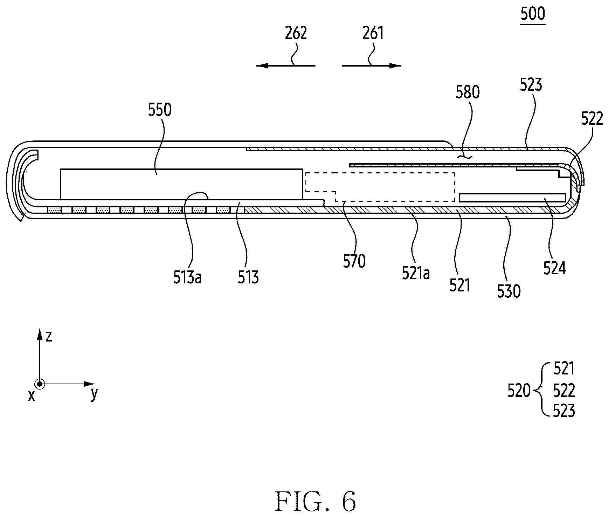

FIG. 6 is a cross-sectional view illustrating an example in which an exemplary electronic device according to an embodiment is cut along line C-C' of FIG. 5B.

Referring to FIG. 6, according to an embodiment, an electronic device 500 may further include a display 530 (e.g., the display 230 of FIG. 2A, FIG. 2B, FIG. 2C, FIG. 2D, FIG. 3A, FIG. 3B, FIG. 4A, and FIG. 4C). The display 530 may be coupled to a second housing 520. For example, the display 530 may be disposed on an outer surface 521a of a front cover 521 of the second housing 520.

According to an embodiment, an airflow path 580 may be disposed between a rear cover 522 and a slide cover 523. For example, between the rear cover 522 and the slide cover 523, the airflow path 580 may extend from a vent hole (e.g., the vent hole 525 of FIG. 5A, FIG. 5B, and FIG. 5C) to an air room 570.

According to an embodiment, as the second housing 520 moves in a first direction 261 (e.g., +y direction), a size of the air room 570 disposed between a battery 550 and a printed circuit board 524 may increase. When the second housing 520 moves in the first direction 261, air of an outside of the electronic device 500 may be introduced into the electronic device 500 through the vent hole 525. The air introduced through the vent hole 525 may move along the airflow path 580 between the rear cover 522 and the slide cover 523. The air may move along the airflow path 580 to an end of the rear cover 522 facing the battery 550 disposed on a surface 513a of the frame cover 513. At the end of the rear cover 522, the air in the airflow path 580 may move to the air room 570 between the battery 550 and the printed circuit board 524.

According to an embodiment, as the second housing 520 moves in a second direction 262(e.g., -y direction), the size of the air room 570 disposed between the battery 550 and the printed circuit board 524 may decrease. When the second housing 520 moves in the second direction 262, the air in the electronic device 500 may flow out to the outside of the electronic device 500 through the vent hole 525. For example, the air within the air room 570 may pass through the end of the rear cover 522 and move along the airflow path 580 between the rear cover 522 and the slide cover 523. The air in the airflow path 580 may move to an end (e.g., the end 580a of FIG. 5A, FIG. 5B, and FIG. 5C) of the airflow path 580 and then move to the outside of the electronic device 500 through the vent hole 525 connected to the end 580a of the airflow path 580.

According to an embodiment, the airflow path 580 may prevent heat generated in the electronic device 500 from being transmitted to an outer surface of the electronic device 500. For example, the airflow path 580 may decrease transmission of heat, generated by the printed circuit board 524, to an outer surface of the slide cover 523. In case that the airflow path 580 is not disposed between the rear cover 522 and the slide cover 523, the heat generated by the printed circuit board 524 may be transmitted to the outer surface of the slide cover 523 through the rear cover 522. The heat transmitted to the outer surface of the slide cover 523 may be transmitted to a user's body gripping the electronic device 500, causing inconvenience to the user. The electronic device 500 according to an embodiment may decrease the heat transmission of the printed circuit board 524 to the outer surface of the electronic device 500 by the airflow path 580 disposed between the rear cover 522 and the slide cover 523. For example, since air with a relatively low thermal conductivity is positioned in the airflow path 580, the heat transmission of the printed circuit board 524 to the outer surface of the electronic device 500 may be decreased.

As described above, the electronic device 500 according to an embodiment may decrease the transmission of the heat generated in the electronic device 500 to the outer surface of the electronic device 500 by the airflow path 580 disposed between the rear cover 522 and the slide cover 523.

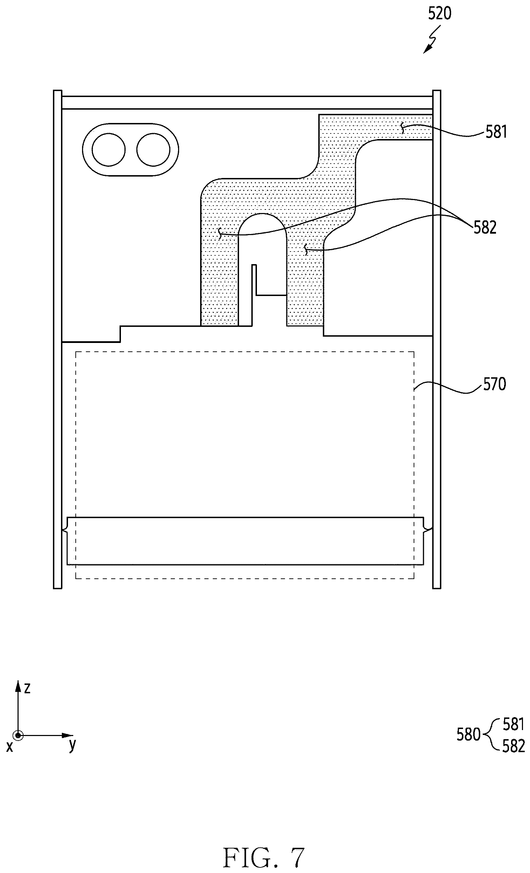

FIG. 7 is a top plan view of a second housing of an exemplary electronic device according to an embodiment.

Referring to FIG. 7, according to an embodiment, an airflow path 580 may include a first extending portion 581 and a second extending portion 582. The first extending portion 581 may be connected to a vent hole 525. The first extending portion 581 may extend from the vent hole 525 in a direction (e.g., -x direction) perpendicular to a moving direction (e.g., +y direction or -y direction) of a second housing 520. The second extending portion 582 may be connected to the first extending portion 581. According to an embodiment, the second extending portion 582 may extend from the first extending portion 581 toward an air room 570. The second extending portion 582 may extend from the first extending portion 581 in a direction (e.g., -y direction) parallel to the moving direction of the second housing 520. According to an embodiment, at least a portion of the second extending portion 582 may be divided between the first extending portion 581 and the air room 570. As at least a portion of the second extending portion 582 is divided, a space in the airflow path 580 decreases, and thus a flow rate of air in the airflow path 580 may increase. As the flow rate of the air in the airflow path 580 increases, an electronic device (e.g., the electronic device 500 of FIG. 5A, FIG. 5B, and FIG. 5C) may provide a structure capable of rapidly emitting heat generated in the electronic device 500.

As described above, the electronic device 500 according to an embodiment may provide the structure capable of rapidly emitting the heat generated in the electronic device 500 by the airflow path 580 disposed in the second housing 520.

An electronic device may include a plurality of electronic components to provide various functions to a user. Heat generated by one of the plurality of electronic components may be transmitted to other electronic components in the electronic device, thereby degrading a function of the electronic device. In case that a separate component (e.g., a fan) for emitting the heat generated in the electronic device is disposed in the electronic device, a space for disposing the components in the electronic device may be decreased or a size of the electronic device may increase. The electronic device may need a structure for emitting the heat generated in the electronic device while saving the space in the electronic device.

According to an embodiment, an electronic device (e.g., the electronic device 500 of FIG. 5A, FIG. 5B, and FIG. 5C) may include a first housing (e.g., the first housing 510 of FIG. 5A and FIG. 5B). According to an embodiment, the electronic device may include a second housing (e.g., the second housing 520 of FIG. 5A, FIG. 5B, and FIG. 5C), coupled to the first housing to be movable with respect to the first housing, including a front cover (e.g., the front cover 521 of FIG. 5A, FIG. 5B, and FIG. 5C), and a rear cover (e.g., the rear cover 522 of FIG. 5A, FIG. 5B, and FIG. 5C) disposed on an inner surface (e.g., the inner surface 521b of FIG. 5C) of the front cover. According to an embodiment, the electronic device may include a flexible display (e.g., the display 530 of FIG. 6), disposed on an outer surface (e.g., the outer surface 521a of FIG. 5C) of the front cover opposite to the inner surface of the front cover, sliding into or out of the first housing by moving of the second housing. According to an embodiment, the electronic device may include a printed circuit board (e.g., the printed circuit board 524 of FIG. 5A, FIG. 5B, and FIG. 5C) disposed between the inner surface of the front cover and an inner surface (e.g., the inner surface 521b of FIG. 5C) of the rear cover facing the inner surface of the front cover. According to an embodiment, the electronic device may include an air room (e.g., the air room 570 of FIG. 5A, FIG. 5B, and FIG. 5C), disposed in an inside of the first and second housings, expanded or contracted by moving of the second housing. According to an embodiment, the electronic device may include a vent hole (e.g., the vent hole 525 of FIG. 5A, FIG. 5B, and FIG. 5C) penetrating the second housing. According to an embodiment, the electronic device may include an airflow path (e.g., the airflow path 580 of FIG. 5A, FIG. 5B, and FIG. 5C) disposed on an outer surface (e.g., the outer surface 522b of FIG. 5C) of the rear cover opposite to the inner surface of the rear cover, extending between the vent hole and the air room, and configured to guide air introduced from the vent hole to the air room or guide air within the air room to the vent hole when the second housing moves.

The electronic device according to an embodiment may provide a structure capable of emitting heat generated in the electronic device by the airflow path that guides moving of air into an inside or to an outside of the electronic device.

According to an embodiment, the airflow path may guide the air introduced from the vent hole to the air room when a size of the air room is expanded by the moving of the second housing. According to an embodiment, the airflow path may guide the air within the air room to the vent hole when the size of the air room is contracted by the moving of the second housing.

The electronic device according to an embodiment may provide a structure capable of emitting heat generated in the electronic device to the outside of the electronic device without separate components through the airflow path that guides a flow of air generated according to the moving of the second housing with respect to the first housing.

According to an embodiment, the vent hole may penetrate a lateral surface (e.g., the lateral surface 521c of FIG. 5A, FIG. 5B, and FIG. 5C) of the front cover extending between the outer surface of the front cover and the inner surface of the rear cover.

Through the vent hole exposed to an outside of the first housing or covered by the first housing, the electronic device according to an embodiment may provide a structure in which the second housing moves smoothly with respect to the first housing.

According to an embodiment, the second housing may be movable in a first direction (e.g., the first direction 261 of FIG. 5A and FIG. 5B) in which the flexible display is slid to the outside of the first housing or in a second direction (e.g., the second direction 262 of FIG. 5A and FIG. 5B) in which the flexible display is slid to the inside of the first housing. According to an embodiment, the vent hole may overlap the first housing in a first state of which the second housing is movable in the first direction among the first and second directions. According to an embodiment, the vent hole may be exposed to the outside of the first housing in a second state of which the second housing is movable in the second direction among the first and second directions.

Through the vent hole exposed to the outside of the first housing or covered by the first housing, the electronic device according to an embodiment may provide the structure in which the second housing moves smoothly with respect to the first housing.

According to an embodiment, a portion of the airflow path may overlap the printed circuit board when the second housing is viewed from above.

Since the airflow path that guides a flow of air generated by moving of the second housing with respect to the first housing overlaps the printed circuit board, the electronic device according to an embodiment may provide a structure capable of emitting heat generated in the electronic device to the outside of the electronic device without separate components.

According to an embodiment, the electronic device may include a battery (e.g., the battery 550 of FIG. 5A and FIG. 5B), spaced apart from the printed circuit board, disposed in the first housing. According to an embodiment, the air room may be formed between the printed circuit board and the battery.

The electronic device according to an embodiment may provide the structure in which the second housing moves smoothly with respect to the first housing by the air room disposed between the printed circuit board and the battery.

According to an embodiment, the airflow path may include a first extending portion (e.g., the first extending portion 581 of FIG. 7), formed from the vent hole in a direction perpendicular to a moving direction of the second housing. According to an embodiment, the airflow path may include a second extending portion (e.g., the second extending portion 582 of FIG. 7), extending from the first extending portion toward the air room, formed in a direction parallel to the moving direction of the second housing.

The electronic device according to an embodiment may provide the structure capable of emitting heat generated in the electronic device by the airflow path that guides moving of air into the inside or to the outside of the electronic device.

According to an embodiment, at least a portion of the second extending portion may be divided between the first extending portion and the air room.

The electronic device according to an embodiment may provide a structure capable of rapidly emitting heat generated in the electronic device by the airflow path disposed in the second housing.

The second housing according to an embodiment may include the slide cover, coupled to the rear cover, covering the airflow path.

The electronic device according to an embodiment may provide a structure in which inflow or outflow of air into the electronic device is smooth by the airflow path disposed on the outer surface of the rear cover.

According to an embodiment, the airflow path may be formed by a portion of the rear cover indented toward an inside of the rear cover.

The electronic device according to an embodiment may provide the structure in which inflow or outflow of air into the electronic device is smooth by the airflow path disposed on the outer surface of the rear cover.

According to an embodiment, the slide cover may overlap the first housing by moving of the second housing. According to an embodiment, the slide cover may be exposed to the outside of the first housing.

According to an embodiment, the electronic device may include a blocking member (e.g., the blocking member 590 of FIG. 5C), disposed on the vent hole, including a plurality of holes.

The electronic device according to an embodiment may provide a structure capable of reducing damage to the electronic device due to a foreign substance by the blocking member disposed on the vent hole.

According to an embodiment, the electronic device may include a motor (e.g., the motor 561 of FIG. 5A and FIG. 5B) disposed in the first housing. According to an embodiment, the electronic device may include a pinion gear (e.g., the pinion gear 562 of FIG. 5A and FIG. 5B), disposed in the first housing, coupled to the motor to be rotatable with respect to the motor. According to an embodiment, the electronic device may include a rack gear (e.g., the rack gear 563 of FIG. 5A and FIG. 5B), disposed on the inner surface of the front cover, movable by rotation of the pinion gear. According to an embodiment, the air room may be formed between the motor and the printed circuit board.

The electronic device according to an embodiment may provide the structure in which the second housing moves smoothly with respect to the first housing by the air room disposed between the printed circuit board and the battery.

According to an embodiment, the printed circuit board may include a processor (e.g., the processor 120 of FIG. 1) disposed on a surface of the printed circuit board.

Since the airflow path that guides a flow of air generated by moving of the second housing with respect to the first housing overlaps the printed circuit board, the electronic device according to an embodiment may provide the structure capable of emitting heat generated in the electronic device to the outside of the electronic device without separate components.

According to an embodiment, the second housing may be movable in the first direction in which the flexible display is slid to the outside of the first housing or the second direction in which the flexible display is slid to the inside of the first housing. According to an embodiment, the size of the air room may increase as the second housing moves in the first direction and decrease as the second housing moves in the second direction.

According to an embodiment, an electronic device (e.g., the electronic device 500 of FIG. 5A, FIG. 5B, and FIG. 5C) may include a first housing (e.g., the first housing 510 of FIG. 5A and FIG. 5B). According to an embodiment, the electronic device may include a second housing (e.g., the second housing 520 of FIG. 5A, FIG. 5B, and FIG. 5C), coupled to the first housing to be slidable with respect to the first housing, including a front cover (e.g., the front cover 521 of FIG. 5A, FIG. 5B, and FIG. 5C), a rear cover (e.g., the rear cover 522 of FIG. 5A, FIG. 5B, and FIG. 5C) disposed on the front cover, and a slide cover (e.g., the slide cover 523 of FIG. 5A, FIG. 5B, and FIG. 5C) disposed on the rear cover. According to an embodiment, the electronic device may include a flexible display (e.g., the display 530 of FIG. 6), disposed on an outer surface (e.g., the outer surface 521a of FIG. 5C) of the front cover, sliding into or out of the first housing by moving of the second housing. According to an embodiment, the electronic device may include a printed circuit board (e.g., the printed circuit board 524 of FIG. 5A, FIG. 5B, and FIG. 5C) disposed on an inner surface (e.g., the inner surface 521b of FIG. 5C) of the front cover opposite to the outer surface of the front cover. According to an embodiment, the electronic device may include a battery (e.g., the battery 550 of FIG. 5A and FIG. 5B), spaced apart from the printed circuit board, disposed in the first housing. According to an embodiment, the electronic device may include an air room (e.g., the air room 570 of FIG. 5A, FIG. 5B, and FIG. 5C), disposed between the printed circuit board and the battery, expanded or contracted by moving of the second housing. According to an embodiment, the electronic device may include a vent hole (e.g., the vent hole 525 of FIG. 5A, FIG. 5B, and FIG. 5C) penetrating the front cover. According to an embodiment, the electronic device may include an airflow path (e.g., the airflow path 580 of FIG. 5A, FIG. 5B, and FIG. 5C) extending, between the rear cover and the slide cover, from the vent hole to the air room and configured to transmit air introduced from the vent hole to the air room or transmit air within the air room to the vent hole when the second housing moves.

According to an embodiment, the airflow path may transmit the air introduced from the vent hole to the air room when a size of the air room is expanded by the moving of the second housing. According to an embodiment, the airflow path may transmit the air within the air room to the vent hole when the size of the air room is contracted by the moving of the second housing.

The electronic device according to an embodiment may provide a structure capable of emitting heat generated in the electronic device by the airflow path that guides moving of air into an inside or to an outside of the electronic device.

According to an embodiment, the vent hole may penetrate a lateral surface (e.g., the lateral surface 521c of FIG. 5A, FIG. 5B, and FIG. 5C) of the front cover perpendicular to the outer surface of the front cover.

Through the vent hole exposed to an outside of the first housing or covered by the first housing, the electronic device according to an embodiment may provide a structure in which the second housing moves smoothly with respect to the first housing.

According to an embodiment, the second housing may be movable in a first direction (e.g., the first direction 261 of FIG. 5A and FIG. 5B) in which the flexible display is slid to the outside of the first housing or in a second direction (e.g., the second direction 262 of FIG. 5A and FIG. 5B) in which the flexible display is slid to an inside of the first housing. According to an embodiment, the vent hole may be covered by the first housing in a first state of which the second housing is movable in the first direction among the first and second directions. According to an embodiment, the vent hole may be exposed to the outside of the first housing in a second state of which the second housing is movable in the second direction among the first and second directions.

Through the vent hole exposed to the outside of the first housing or covered by the first housing, the electronic device according to an embodiment may provide the structure in which the second housing moves smoothly with respect to the first housing.

According to an embodiment, a portion of the airflow path may overlap the printed circuit board when the second housing is viewed from above.

Since the airflow path that guides a flow of air generated by moving of the second housing with respect to the first housing overlaps the printed circuit board, the electronic device according to an embodiment may provide a structure capable of emitting heat generated in the electronic device to the outside of the electronic device without separate components.

It should be understood that when an element is mentioned as being "on" another element, it may be that there is directly on the other element, or it may be that intervening elements exist therebetween. In contrast, when an element is referred to as being "directly on" another element, no intervening elements exist.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes or replacements for a corresponding embodiment, as covered by the appended claims. With regard to the description of the drawings, similar reference numerals may be used to refer to similar or related elements. It is to be understood that a singular form of a noun corresponding to an item may include one or more of the things unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," or "connected with" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between a case in which data is semi-permanently stored in the storage medium and a case in which the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

## Claims

1. An electronic device (101; 500) comprising:
a first housing (210; 510);
a second housing (220; 520) coupled to the first housing (210; 510) and configured to be slidable with respect to the first housing (210; 510), the second housing (220; 520) including a front cover (321; 521) and a rear cover (522), and including a vent hole (525),
the vent hole (525) penetrating the second housing;
a flexible display (230; 530) configured to be slid into or out of the first housing (210; 510) by sliding of the second housing (220; 520) with respect to the first housing (210; 510); and
a printed circuit board (324; 524) disposed between the front cover (321; 521) and the rear cover (522),
wherein an air room (570), expanded or contracted by sliding of the second housing (220; 520) with respect to the first housing (210; 510), is defined inside of the electronic device, and
**characterized in that**
an outer surface (522b) of the rear cover (522) of the second housing (220; 520) defines an airflow path (580), extending from the vent hole (525) to the air room (570), wherein at least a portion of the airflow path (580) overlaps the printed circuit board (324; 524) when the second housing (220; 520) is viewed from above.

2. The electronic device (101; 500) of claim 1,
wherein the airflow path (580) is configured to transmit:
air introduced from the vent hole (525) to the air room (570), when the air room (570) is expanded by the sliding of the second housing (220; 520) with respect to the first housing (210; 510); and
air within the air room (570) to the vent hole (525), when the air room (570) is contracted by the sliding of the second housing (220; 520) with respect to the first housing (210; 510).

3. The electronic device (101; 500) of any one of claims 1 and 2,
wherein the vent hole (525) penetrates a lateral surface of the front cover (321; 521) perpendicular to an outer surface (521a) of the front cover (321; 521).

4. The electronic device (101; 500) of any one of claims 1 to 3,
wherein the second housing (220; 520) is slidable in a first direction in which the flexible display (230; 530) is slid out of the first housing (210; 510) and in a second direction in which the flexible display (230; 530) is slid into the first housing (210; 510),
wherein the vent hole (525) is covered by the first housing (210; 510) in a first state in which the second housing (220; 520) is slidable in the first direction among the first and second directions, and
wherein the vent hole (525) is exposed to an outside of the first housing (210; 510) in a second state in which the second housing (220; 520) is slidable in the second direction among the first and second directions.

5. The electronic device (101; 500) of claim 4,
wherein the air room (570) is configured to be expanded as the second housing (220; 520) slides in the first direction and to be contracted as the second housing (220; 520) slides in the second direction.

6. The electronic device (101; 500) of any one of claims 1 to 5 further comprising:
a battery (189; 550), spaced apart from the printed circuit board (324; 524), disposed in the first housing (210; 510), and
wherein the air room (570) is disposed between the printed circuit board (324; 524) and the battery (189; 550).

7. The electronic device (101; 500) of any one of claims 1 to 6,
wherein the airflow path (580) includes:
a first extending portion (581) extending from the vent hole (525) in a direction perpendicular to a sliding direction of the second housing (220; 520) with respect to the first housing (210; 510); and
a second extending portion (582), extending from the first extending portion (581) toward the air room (570), extending in a direction parallel to the sliding direction of the second housing (220; 520) with respect to the first housing (210; 510).

8. The electronic device (101; 500) of claim 7,
wherein at least a portion of the second extending portion (582) is divided between the first extending portion (581) and the air room (570).

9. The electronic device (101; 500) of any one of claims 1 to 8,
wherein the second housing (220; 520) includes a slide cover (322; 523), disposed on the outer surface (522b) of the rear cover (522), covering the airflow path (580).

10. The electronic device (101; 500) of any one of claims 1 to 9,
wherein the airflow path (580) is defined by a portion of the outer surface (522b) of the rear cover (522) indented toward an inside of the rear cover (522).

11. The electronic device (101; 500) of claim 9,
wherein the slide cover (322; 523) is covered by the first housing (210; 510) or exposed to the outside of the first housing (210; 510), by sliding of the second housing (220; 520) with respect to the first housing (210; 510).

12. The electronic device (101; 500) of any one of claims 1 to 11 further comprising a blocking member (590), disposed to cover the vent hole (525), configured to block entry of foreign substances through the vent hole (525).

13. The electronic device (101; 500) of any one of claims 1 to 12 further comprising:
a motor disposed in the first housing (210; 510);
a pinion gear, disposed in the first housing (210; 510), coupled to the motor and configured to be rotatable with respect to the motor; and
a rack gear, disposed on an inner surface (521b) of the front cover (321; 521), and configured to be movable by rotation of the pinion gear, and
wherein the air room (570) is disposed between the motor and the printed circuit board (324; 524).

14. The electronic device (101; 500) of any one of claims 1 to 13,
wherein the printed circuit board (324; 524) includes a processor disposed on the printed circuit board.

## Patentansprüche

1. Elektronische Vorrichtung (101; 500), die Folgendes umfasst:
ein erstes Gehäuse (210; 510);
ein zweites Gehäuse (220; 520), das mit dem ersten Gehäuse (210; 510) gekoppelt und so konfiguriert ist, dass es in Bezug auf das erste Gehäuse (210; 510) verschiebbar ist, wobei das zweite Gehäuse (220; 520) eine vordere Abdeckung (321; 521) und eine hintere Abdeckung (522) enthält und ein Entlüftungsloch (525) enthält, wobei das Entlüftungsloch (525) das zweite Gehäuse durchdringt;
ein flexibles Display (230; 530), das so konfiguriert ist, dass es in das oder aus dem ersten Gehäuse (210; 510) geschoben werden kann, indem das zweite Gehäuse (220; 520) in Bezug auf das erste Gehäuse (210; 510) verschoben wird; und
eine Leiterplatte (324; 524), die zwischen der vorderen Abdeckung (321; 521) und der hinteren Abdeckung (522) angeordnet ist,
wobei ein Luftraum (570), der durch das Verschieben des zweiten Gehäuses (220; 520) in Bezug auf das erste Gehäuse (210; 510) erweitert oder reduziert wird, innerhalb der elektronischen Vorrichtung definiert ist, und
**gekennzeichnet dadurch, dass**
eine Außenfläche (522b) der hinteren Abdeckung (522) des zweiten Gehäuses (220; 520) einen Luftstrompfad (580) definiert, der sich von dem Entlüftungsloch (525) zu dem Luftraum (570) erstreckt, wobei zumindest ein Teil des Luftstrompfads (580) die Leiterplatte (324; 524) überlappt, wenn das zweite Gehäuse (220; 520) von oben betrachtet wird.

2. Elektronische Vorrichtung (101; 500) nach Anspruch 1,
wobei der Luftstrompfad (580) so konfiguriert ist, dass er Folgendes überträgt:
Luft, die von dem Entlüftungsloch (525) in den Luftraum (570) eingeleitet wird, wenn der Luftraum (570) durch das Verschieben des zweiten Gehäuses (220; 520) in Bezug auf das erste Gehäuse (210; 510) erweitert wird; und
Luft in dem Luftraum (570) an das Entlüftungsloch (525), wenn der Luftraum (570) durch das Verschieben des zweiten Gehäuses (220; 520) in Bezug auf das erste Gehäuse (210; 510) reduziert wird.

3. Elektronische Vorrichtung (101; 500) nach einem der Ansprüche 1 und 2,
wobei das Entlüftungsloch (525) eine Seitenfläche der vorderen Abdeckung (321; 521) senkrecht zu einer Außenfläche (521a) der vorderen Abdeckung (321; 521) durchdringt.

4. Elektronische Vorrichtung (101; 500) nach einem der Ansprüche 1 bis 3,
wobei das zweite Gehäuse (220; 520) in eine erste Richtung verschiebbar ist, in die das flexible Display (230; 530) aus dem ersten Gehäuse (210; 510) herausgeschoben wird, und in eine zweite Richtung, in die das flexible Display (230; 530) in das erste Gehäuse (210; 510) hineingeschoben wird,
wobei das Entlüftungsloch (525) durch das erste Gehäuse (210; 510) in einem ersten Zustand abgedeckt ist, in dem das zweite Gehäuse (220; 520) in die erste Richtung zwischen der ersten und zweiten Richtung verschiebbar ist, und
wobei das Entlüftungsloch (525) zu einer Außenseite des ersten Gehäuses (210; 510) in einem zweiten Zustand freiliegt, in dem das zweite Gehäuse (220; 520) in die zweite Richtung zwischen der ersten und zweiten Richtung verschiebbar ist.

5. Elektronische Vorrichtung (101; 500) nach Anspruch 4,
wobei der Luftraum (570) so konfiguriert ist, dass er erweitert wird, wenn das zweite Gehäuse (220; 520) in die erste Richtung gleitet, und reduziert wird, wenn das zweite Gehäuse (220; 520) in die zweite Richtung gleitet.

6. Elektronische Vorrichtung (101; 500) nach einem der Ansprüche 1 bis 5, die ferner Folgendes umfasst:
eine Batterie (189; 550), die von der Leiterplatte (324; 524) beabstandet ist und in dem ersten Gehäuse (210; 510) angeordnet ist, und
wobei der Luftraum (570) zwischen der Leiterplatte (324; 524) und der Batterie (189; 550) angeordnet ist.

7. Elektronische Vorrichtung (101; 500) nach einem der Ansprüche 1 bis 6,
wobei der Luftstrompfad (580) Folgendes enthält:
einen ersten Verlängerungsabschnitt (581), der sich von dem Entlüftungsloch (525) in eine Richtung senkrecht zu einer Gleitrichtung des zweiten Gehäuses (220; 520) in Bezug auf das erste Gehäuse (210; 510) erstreckt; und
einen zweiten Verlängerungsabschnitt (582), der sich von dem ersten Verlängerungsabschnitt (581) in Richtung des Luftraums (570) erstreckt, der sich in eine Richtung parallel zu der Gleitrichtung des zweiten Gehäuses (220; 520) in Bezug auf das erste Gehäuse (210; 510) erstreckt.

8. Elektronische Vorrichtung (101; 500) nach Anspruch 7,
wobei zumindest ein Teil des zweiten Verlängerungsabschnitts (582) zwischen dem ersten Verlängerungsabschnitt (581) und dem Luftraum (570) aufgeteilt ist.

9. Elektronische Vorrichtung (101; 500) nach einem der Ansprüche 1 bis 8,
wobei das zweite Gehäuse (220; 520) eine Schiebeabdeckung (322; 523) enthält, die auf der Außenfläche (522b) der hinteren Abdeckung (522) angeordnet ist und den Luftstrompfad (580) abdeckt.

10. Elektronische Vorrichtung (101; 500) nach einem der Ansprüche 1 bis 9,
wobei der Luftstrompfad (580) durch einen Teil der Außenfläche (522b) der hinteren Abdeckung (522) definiert ist, der in Richtung einer Innenseite der hinteren Abdeckung (522) eingerückt ist.

11. Elektronische Vorrichtung (101; 500) nach Anspruch 9,
wobei die Schiebeabdeckung (322; 523) durch das erste Gehäuse (210; 510) abgedeckt ist oder zu der Außenseite des ersten Gehäuses (210; 510) freiliegt, wenn das zweite Gehäuse (220; 520) in Bezug auf das erste Gehäuse (210; 510) gleitet.

12. Elektronische Vorrichtung (101; 500) nach einem der Ansprüche 1 bis 11, die ferner ein Sperrelement (590) umfasst, das so angeordnet ist, dass es das Entlüftungsloch (525) abdeckt, und so konfiguriert ist, dass es das Eindringen von Fremdstoffen durch das Entlüftungsloch (525) blockiert.

13. Elektronische Vorrichtung (101; 500) nach einem der Ansprüche 1 bis 12, die ferner Folgendes umfasst:
einen Motor, der in dem ersten Gehäuse (210; 510) angeordnet ist;
ein Ritzel, das in dem ersten Gehäuse (210; 510) angeordnet ist, mit dem Motor gekoppelt ist und so konfiguriert ist, dass es in Bezug auf den Motor drehbar ist; und
eine Zahnstange, die auf einer Innenfläche (521b) der vorderen Abdeckung (321; 521) angeordnet ist und so konfiguriert ist, dass sie durch Drehung des Ritzels beweglich ist, und
wobei der Luftraum (570) zwischen dem Motor und der Leiterplatte (324; 524) angeordnet ist.

14. Elektronische Vorrichtung (101; 500) nach einem der Ansprüche 1 bis 13, wobei die Leiterplatte (324; 524) einen Prozessor enthält, der auf der Leiterplatte angeordnet ist.

## Revendications

1. Dispositif électronique (101 ; 500) comprenant :
un premier boîtier (210 ; 510) ;
un deuxième boîtier (220 ; 520) couplé au premier boîtier (210 ; 510) et configuré pour pouvoir coulisser par rapport au premier boîtier (210 ; 510), le deuxième boîtier (220 ; 520) comprenant un couvercle avant (321 ; 521) et un couvercle arrière (522), et comprenant un orifice d'aération (525), l'orifice d'aération (525) pénétrant le deuxième boîtier ;
une unité d'affichage flexible (230 ; 530) configurée pour être coulissé dans ou hors du premier boîtier (210 ; 510) par coulissement du deuxième boîtier (220 ; 520) par rapport au premier boîtier (210 ; 510) ; et
une carte de circuit imprimé (324 ; 524) disposée entre le couvercle avant (321 ; 521) et le couvercle arrière (522),
où une chambre à air (570), dilatée ou contractée par coulissement du deuxième boîtier (220 ; 520) par rapport au premier boîtier (210 ; 510), est définie à l'intérieur du dispositif électronique, et
**caractérisé en ce que**
une surface extérieure (522b) du couvercle arrière (522) du deuxième boîtier (220 ; 520) définit un circuit d'écoulement d'air (580), s'étendant depuis l'orifice d'aération (525) jusqu'à la chambre à air (570), où au moins une partie du circuit d'écoulement d'air (580) chevauche la carte de circuit imprimé (324 ; 524) lorsque le deuxième boîtier (220 ; 520) est vu de dessus.

2. Dispositif électronique (101 ; 500) selon la revendication 1,
où le circuit d'écoulement d'air (580) est configuré pour transmettre :
de l'air introduit par l'orifice d'aération (525) à la chambre à air (570), lorsque la chambre à air (570) est dilatée par le coulissement du deuxième boîtier (220 ; 520) par rapport au premier boîtier (210 ; 510) ; et
de l'air contenu dans la chambre à air (570) à l'orifice d'aération (525), lorsque la chambre à air (570) est contractée par le coulissement du deuxième boîtier (220 ; 520) par rapport au premier boîtier (210 ; 510).

3. Dispositif électronique (101 ; 500) selon l'une quelconque des revendications 1 et 2,
où l'orifice d'aération (525) pénètre une surface latérale du couvercle avant (321 ; 521) perpendiculairement à une surface extérieure (521a) du couvercle avant (321 ; 521).

4. Dispositif électronique (101 ; 500) selon l'une quelconque des revendications 1 à 3,
où le deuxième boîtier (220 ; 520) peut coulisser dans une première direction dans laquelle l'unité d'affichage flexible (230 ; 530) est coulissée hors du premier boîtier (210 ; 510) et dans une deuxième direction dans laquelle l'unité d'affichage flexible (230 ; 530) est coulissée dans le premier boîtier (210 ; 510),
où l'orifice d'aération (525) est recouvert par le premier boîtier (210 ; 510) dans un premier état dans lequel le deuxième boîtier (220 ; 520) peut coulisser dans la première direction parmi la première direction et la deuxième direction, et
où l'orifice d'aération (525) est exposé à l'extérieur du premier boîtier (210 ; 510) dans un deuxième état dans lequel le deuxième boîtier (220 ; 520) peut coulisser dans la deuxième direction parmi la première direction et la deuxième direction.

5. Dispositif électronique (101 ; 500) selon la revendication 4,
où la chambre à air (570) est configurée pour être dilatée lorsque le deuxième boîtier (220 ; 520) coulisse dans la première direction et pour être contractée lorsque le deuxième boîtier (220 ; 520) coulisse dans la deuxième direction.

6. Dispositif électronique (101 ; 500) selon l'une quelconque des revendications 1 à 5 comprenant en outre :
une batterie (189 ; 550), espacée de la carte de circuit imprimé (324 ; 524), disposée dans le premier boîtier (210 ; 510), et
où la chambre à air (570) est disposée entre la carte de circuit imprimé (324 ; 524) et la batterie (189 ; 550).

7. Dispositif électronique (101 ; 500) selon l'une quelconque des revendications 1 à 6,
où le circuit d'écoulement d'air (580) comprend :
une première partie d'extension (581) s'étendant depuis l'orifice d'aération (525) dans une direction perpendiculaire à une direction de coulissement du deuxième boîtier (220 ; 520) par rapport au premier boîtier (210 ; 510) ; et
une deuxième partie d'extension (582), s'étendant depuis la première partie d'extension (581) vers la chambre à air (570), s'étendant dans une direction parallèle à la direction de coulissement du deuxième boîtier (220 ; 520) par rapport au premier boîtier (210 ; 510).

8. Dispositif électronique (101 ; 500) selon la revendication 7,
où au moins une partie de la deuxième partie d'extension (582) est divisée entre la première partie d'extension (581) et la chambre à air (570).

9. Dispositif électronique (101 ; 500) selon l'une quelconque des revendications 1 à 8,
où le deuxième boîtier (220 ; 520) comprend un couvercle coulissant (322; 523), disposé sur la surface extérieure (522b) du couvercle arrière (522), recouvrant le circuit d'écoulement d'air (580).

10. Dispositif électronique (101 ; 500) selon l'une quelconque des revendications 1 à 9,
où le circuit d'écoulement d'air (580) est défini par une partie de la surface extérieure (522b) du couvercle arrière (522) indentée vers l'intérieur du couvercle arrière (522).

11. Dispositif électronique (101 ; 500) selon la revendication 9,
où le couvercle coulissant (322 ; 523) est recouvert par le premier boîtier (210 ; 510) ou exposé à l'extérieur du premier boîtier (210 ; 510), par coulissement du deuxième boîtier (220 ; 520) par rapport au premier boîtier (210; 510).

12. Dispositif électronique (101 ; 500) selon l'une quelconque des revendications 1 à 11 comprenant en outre un élément de blocage (590), disposé pour recouvrir l'orifice d'aération (525), configuré pour bloquer l'entrée de substances étrangères à travers l'orifice d'aération (525).

13. Dispositif électronique (101 ; 500) selon l'une quelconque des revendications 1 à 12 comprenant en outre :
un moteur disposé dans le premier boîtier (210 ; 510) ;
un pignon d'engrenage, disposé dans le premier boîtier (210 ; 510), couplé au moteur et configuré pour être rotatif par rapport au moteur ; et
un engrenage à crémaillère, disposé sur une surface intérieure (521b) du couvercle avant (321 ; 521), et configuré pour être mobile par rotation du pignon d'engrenage, et
où la chambre à air (570) est disposée entre le moteur et la carte de circuit imprimé (324 ; 524).

14. Dispositif électronique (101 ; 500) selon l'une quelconque des revendications 1 à 13,
où la carte de circuit imprimé (324 ; 524) comprend un processeur disposé sur la carte de circuit imprimé.
